(19) **Europäisches Patentamt**
**European Patent Office**
**Office européen des brevets**

(11) **EP 3 709 590 B1**

(12) **FASCICULE DE BREVET EUROPEEN**

(45) Date de publication et mention
de la délivrance du brevet:
**03.08.2022 Bulletin 2022/31**

(21) Numéro de dépôt: **20163041.5**

(22) Date de dépôt: **13.03.2020**

(51) Classification Internationale des Brevets (IPC):
$H04L\ 27/34^{(2006.01)}$    $H04L\ 27/36^{(2006.01)}$
$H04L\ 27/38^{(2006.01)}$    $H04L\ 1/00^{(2006.01)}$
$H03M\ 7/16^{(2006.01)}$    $H03M\ 13/25^{(2006.01)}$

(52) Classification Coopérative des Brevets (CPC):
**H04L 27/3405; H04L 1/0003; H04L 27/36;
H04L 27/38;** H03M 13/255

(54) **MÉTHODE D'ADAPTATION DE LIAISON UTILISANT UNE CONSTELLATION DE MODULATION POLAIRE**

METHODE FÜR DIE VERBINDUNGSANPASSUNG, DIE EINE KONSTELLATION MIT POLARER MODULATION VERWENDET

METHOD FOR LINK ADAPTATION USING A POLAR MODULATION CONSTELLATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.03.2019 FR 1902720**

(43) Date de publication de la demande:
**16.09.2020 Bulletin 2020/38**

(73) Titulaire: **Commissariat à l'énergie atomique et aux énergies alternatives**
**75015 Paris (FR)**

(72) Inventeurs:
• **BICAÏS, Simon**
**38054 Grenoble Cedex 9 (FR)**
• **DORE, Jean-Baptiste**
**38054 Grenoble Cedex 9 (FR)**
• **GONZALES JIMENEZ, José-Luis**
**38054 Grenoble Cedex 9 (FR)**

(74) Mandataire: **Brevalex**
**56, Boulevard de l'Embouchure**
**B.P. 27519**
**31075 Toulouse Cedex 2 (FR)**

(56) Documents cités:
**WO-A1-2018/116411**    **US-A- 5 828 695**

• **DENG LIANJUN ET AL: "Performance of circular QAM constellations using partial channel coding with parallel double gray mapping", 2016 19TH INTERNATIONAL SYMPOSIUM ON WIRELESS PERSONAL MULTIMEDIA COMMUNICATIONS (WPMC), NATIONAL INSTITUTE OF INFORMATION AND COMMUNICATIONS TECHNOLOGY (NICT), 14 novembre 2016 (2016-11-14), pages 400-405, XP033106608,**
• **BERNHARD GOEBEL ET AL: "Calculation of Mutual Information for Partially Coherent Gaussian Channels With Applications to Fiber Optics", IEEE TRANSACTIONS ON INFORMATION THEORY, IEEE PRESS, USA, vol. 57, no. 9, 1 septembre 2011 (2011-09-01), pages 5720-5736, XP011382281, ISSN: 0018-9448, DOI: 10.1109/TIT.2011.2162187**

**Description**

**DOMAINE TECHNIQUE**

La présente invention concerne le domaine de la modulation numérique, et plus particulièrement des modulations APSK *(Amplitude and Phase Shift Keying)* à très haut débit. Elle trouve notamment application dans les communications sub-THz envisagées dans les futurs standards de télécommunication.

**ÉTAT DE LA TECHNIQUE ANTÉRIEURE**

La demande croissante en débit de la part des utilisateurs a conduit à l'émergence de nouvelles solutions technologiques dans les réseaux de télécommunication mobile de de dernière génération, telles que MIMO *(Multiple Input Multiple Output)* massif, densification cellulaire au moyen de petites cellules, accès multi-RAT *(Radio Access Technology)* exploitant conjointement la bande sub-6 GHz et la bande millimétrique. Plus récemment il a été proposé d'utiliser des bandes spectrales entre 100 et 300 GHz, dites sub-THz pour des communications à très haut débit. Ces communications sub-THz sont envisagées par exemple pour les liaisons point à multipoint où une station de base transmet des données à très haut débit et faible distance à une pluralité de terminaux mobiles sur la voie descendante ou bien pour établir des liaisons point à point entre stations de base dans le réseau de backhaul.

L'exploitation des bandes sub-THz suppose toutefois de résoudre des problèmes de consommation énergétique, de stabilité des oscillateurs et de pouvoir atteindre des ordres de modulation élevés. La difficulté à réaliser des oscillateurs stables dans cette gamme de fréquence ainsi que la nécessité d'utiliser des ordres de modulation élevés pour obtenir des débits de données toujours plus importants font que les systèmes de communication sub-THz sont très sensibles au bruit de phase. Ce bruit de phase affecte aussi bien l'oscillateur de l'émetteur que celui du récepteur. À ce bruit de phase s'ajoute le problème classique de décalage entre la fréquence de l'oscillateur du récepteur et celle de l'oscillateur de l'émetteur ou CFO *(Frequency Offset).* Le taux d'erreur symbole peut alors devenir très élevé.

Différentes stratégies d'optimisation de constellations de modulation ont été proposées dans l'état de la technique pour minimiser le taux d'erreur symbole. En particulier, l'article de C. Häger et al. intitulé « Design of APSK constellations for coherent optical channels with nonlinear phase noise », IEEE Transactions on Communications, vol. 61, n° 8 , août 2013, divulgue des constellations de modulation présentant une bonne robustesse à un bruit de phase non linéaire dans le cas où le récepteur utilise un module de détection sous-optimal à deux étages, un premier étage effectuant une détection d'amplitude et une correction de phase, et un second étage effectuant une détection de phase.

L'article de L. Deng et al intitulé « Performance of circular QAM constellations using partial channel coding with parallel double gray mapping » publié dans Proc. of 19th Int'l Symposium on Wireless Personal Multimedia Communications (WPMC) le 14.11.2016, décrit une famille de constellations de modulation polaire avec un codage de Gray radial et un codage de Gray circulaire.

Toutefois, ces stratégies ne sont pas optimales dans la mesure où elles ne recherchent pas à minimiser le taux d'erreur binaire ou BER *(Bit Error Rate)* mais simplement le taux d'erreur symbole ou SEP *(Symbol Error Probability).* En outre, les constellations obtenues ne sont pas structurées et donc difficilement exploitables pour des ordres de modulation élevés. Enfin, ces stratégies sont silencieuses sur la manière d'adapter la liaison entre l'émetteur et le récepteur en présence de bruit de phase, pour obtenir de faibles taux d'erreur binaire.

**EXPOSÉ DE L'INVENTION**

La présente invention est définie par une méthode d'adaptation de liaison comme revendiquée ci-après. Des variantes de réalisation sont précisées dans les revendications dépendantes.

**BRÈVE DESCRIPTION DES DESSINS**

D'autres caractéristiques et avantages de l'invention apparaîtront à la lecture d'un mode de réalisation préférentiel de l'invention, décrit en référence aux figures jointes parmi lesquelles :

La Fig. 1 représente un exemple de constellation de modulation utilisé par une méthode de modulation selon un mode de réalisation de la présente invention ;
Les Figs. 2A et 2B représentent des courbes de taux d'erreur binaire en fonction du rapport signal sur bruit pour une méthode de modulation PQAM et une méthode de modulation QAM classique ;
La Fig. 3 représente un diagramme de sélection d'une constellation de modulation par une méthode d'adaptation de liaison selon un mode de réalisation de l'invention ;
La Fig. 4 représente l'organigramme d'une méthode d'adaptation de liaison selon un mode de réalisation de l'invention.

## EXPOSÉ DÉTAILLÉ DE MODES DE RÉALISATION PARTICULIERS

On considérera dans la suite une communication sur un canal de transmission affecté d'un bruit de phase entre un émetteur et un récepteur. Par exemple, la communication pourra être celle entre une station de base et un terminal mobile dans la bande sub-THz. De récentes campagnes de mesures ont montré que le trajet direct ou LOS *(Line Of Sight)* dominait dans de telles communications.

Le signal reçu en bande de base à l'instant k peut s'exprimer sous la forme :

$$r(k) = s(k)e^{j\varphi(k)} + n(k) \tag{1}$$

où $s(k)$ est le symbole émis à l'instant $k$, $\varphi(k)$ est le bruit de phase représentant la somme du bruit de phase de l'émetteur et celui du récepteur, $n(k)$ est un échantillon de bruit blanc additif gaussien (AWGN) de variance $\sigma_n^2$ .

Le bruit de phase peut être considéré comme la somme d'une variable aléatoire gaussienne (de variance $\sigma_p^2$ ) et d'un processus stochastique de Wiener (encore dénommé de Wiener-Lévy) c'est à dire à accroissements indépendants stationnaires suivant une loi gaussienne (de variance $\sigma_w^2$ ). On peut montrer que la densité spectrale du bruit de phase est la somme d'une constante (bruit blanc) et d'une contribution lorentzienne (processus de Wiener-Lévy). La contribution lorentzienne est prépondérante aux basses fréquences mais devient négligeable devant la composante de bruit blanc au-dessus d'une fréquence de coupure proportionnelle au rapport $\dfrac{\sigma_w^2}{\sigma_p^2}$ . Lorsque cette fréquence de coupure, $f_c$, est inférieure à $\dfrac{B.c}{\sqrt{N}}$ où $B$ est la largeur de bande utilisée pour la transmission, $N$ est la longueur d'une trame transmise et $c = \sqrt{\dfrac{\ln 2}{2\pi^2}}$ , la contribution lorentzienne peut être négligée. Cette condition étant généralement vérifiée dans les communications sub-THz, nous supposerons dans la suite, sauf mention contraire, que la contribution lorentzienne peut être négligée dans le bruit de phase.

La méthode de modulation numérique utilisée par la présente invention transforme des mots de m bits en des symboles complexes appartenant à une constellation de modulation, C, d'ordre $M$ où $M = 2^m$, les symboles complexes modulant une porteuse au moyen d'une modulation en quadrature.

Lesdits symboles complexes sont répartis sur $\Gamma = 2^n$ cercles concentriques équidistants où $m > n + 1$ et $n > 1$, chacun des cercles concentriques portant une même pluralité $M/\Gamma$ de symboles. La distribution angulaire des symboles complexes est uniforme et identique sur chacun des cercles concentriques. Plus précisément, la constellation C est défini par l'ensemble de symboles complexes :

$$C = \left\{ \left( \frac{\delta\rho}{2}(2q-1)\exp\left( j\frac{\delta\theta}{2}(2p-1) \right) \right) \middle| 1 \le q \le \Gamma; 1 \le p \le \frac{M}{\Gamma} \right\} \tag{2}$$

où $\delta\rho = \sqrt{E_s} \cdot \sqrt{\dfrac{12}{4\Gamma^2 - 1}}$ est la distance radiale entre cercles concentriques consécutifs, $E_s$ est la puissance moyenne des symboles de la constellation, et où $\delta\theta = 2\pi\dfrac{\Gamma}{M}$ est l'écart M angulaire entre deux symboles consécutifs sur un même cercle concentrique. Ainsi la constellation de modulation est paramétrée par l'ordre de modulation, *M*, et le nombre de cercles concentriques, $\Gamma$. Elle sera donc notée dans la suite *C(M,$\Gamma$)*.

Les symboles successifs sur un cercle correspondant à deux mots de m bits présentant une distance de Hamming égale à 1. De la même façon, deux symboles disposés sur même rayon, c'est-à-dire alignés selon une même direction angulaire, et appartenant à deux cercles concentriques successifs, correspondent à deux mots de *m* bits présentant une distance de Hamming égale à 1. En d'autres termes, deux symboles de modulation adjacents, qu'ils soient situés sur un même cercle ou sur un même rayon de la constellation représentent des mots ne différant que d'un seul bit.

À cette fin, chaque mot de m bits à moduler est codé en un mot d'un premier code de Gray de taille n et en un mot d'un second code de Gray de taille *(m-n)*. En d'autres termes, le mot à moduler bw peut être représenté par :

$$bw = \left( b_1^\rho, .., b_n^\rho, b_1^\theta, .., b_{m-n}^\theta \right) \qquad (3)$$

Il est constitué d'une première portion, $b_1^\rho, .., b_n^\rho$ , donnant l'indice du cercle concentrique sur lequel se trouve le symbole de modulation et d'une seconde portion, $b_1^\theta, .., b_{m-n}^\theta$ , donnant l'indice de l'argument de ce symbole complexe.

En définitive, la modulation numérique utilisée par la présente invention peut être considérée comme une fonction bijective F de $\{0,1\}^m$ dans *C(M,$\Gamma$)*telle que :

$$F(bw) = \frac{\delta\rho}{2}(2q-1).\exp\left( j\frac{\delta\theta}{2}(2p-1) \right) \qquad (4)$$

où q est l'entier correspondant au mot du premier code de Gray $b_1^\rho, .., b_n^\rho$ et *p* est l'entier correspondant au mot du second code de Gray $b_1^\theta, .., b_{m-n}^\theta$ . Cette méthode de modulation sera dénommée conventionnellement PQAM (Polar-QAM).

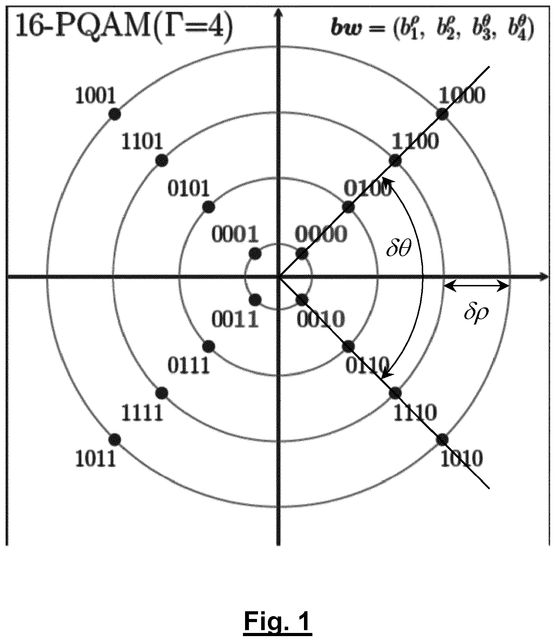

La Fig. 1 représente une constellation de modulation numérique PQAM pouvant être utilisée dans le cadre de la présente invention.

Plus précisément, la constellation représentée est la constellation C(16,4) , c'est-à-dire d'ordre *M* = 16 (*m*= 4) et de nombre de cercles concentriques $\Gamma$ = 4 (*n* = 2). La distance radiale entre cercles concentriques est indiquée par $\delta p$ et l'écart angulaire entre symboles successifs d'un même cercle est noté $\delta\theta$ (ici $\delta\theta$ = $\pi$/2). Dans le cas présent, les deux bits de poids fort (MSB) constituent un premier code de Gray indexant les cercles concentriques. Les deux bits de poids fort (LSB) constituent un second code de Gray indexant les symboles sur même cercle.

À la réception, les décisions sur les symboles sont prises à partir des coordonnées polaires $(\rho_r, \theta_r)$ du signal reçu r. Par la suite, nous utiliserons la notation $(\rho_s, \theta_s)$ pour désigner les coordonnées polaires d'un symbole s .

En absence de codage, les bits pourront être estimés en prenant une décision dure à partir du signal reçu. Plus précisément, le symbole transmis sera avantageusement estimé par le récepteur au moyen de :

$$\hat{\mathbf{s}} = \arg\min_{\mathbf{s} \in C} \left[ (\rho_s - \rho_r)^2 + \frac{1}{\gamma^2}(\theta_s - \theta_r)^2 \right] \qquad (5)$$

Les bits transmis étant ensuite estimés par $(\hat{b}_1, ..., \hat{b}_m) = F^{-1}(\hat{\mathbf{s}})$. Le terme entre crochets est une distance définie en coordonnées polaires, $d_\gamma(\mathbf{s,r})$ définie par :

$$d_\gamma^2(\mathbf{s,r}) = (\rho_s - \rho_r)^2 + \frac{1}{\gamma^2}(\theta_s - \theta_r)^2 \qquad (6)$$

$$\gamma = \frac{\sigma_p^2}{\sigma_n^2} + \frac{1}{E_s} \quad , \quad \frac{\sigma_p^2}{\sigma_n^2}$$

où $\frac{\sigma_p^2}{\sigma_n^2}$ est le rapport entre la puissance du bruit de phase et celle du bruit (thermique) additif sur le canal, et $E_s$ est l'énergie moyenne des symboles de la constellation.

En présence de codage à entrée probabiliste, par exemple codage LDPC, les bits transmis peuvent être estimés par décision souple en calculant les rapports logarithmiques de vraisemblance :

$$LLR(b_i) = \log\left(\frac{p(b_i = 1|\mathbf{r})}{p(b_i = 0|\mathbf{r})}\right) \qquad (7)$$

où $p(b_i = \eta|\mathbf{r})$ représente la probabilité que le bit $b_i$ vaut $\eta$ sachant que le signal reçu est la valeur complexe r. Les rapports logarithmiques de vraisemblance peuvent être calculés par :

$$LLR(b_i) = \log\left(\frac{\sum_{\mathbf{s}_1 \in C_1^i} p(\mathbf{r}|\mathbf{s}_1)}{\sum_{\mathbf{s}_0 \in C_0^i} p(\mathbf{r}|\mathbf{s}_0)}\right) \qquad (8)$$

où $C_0^i$ (resp. $C_1^i$) est un sous-ensemble de symboles de $C(M,\Gamma)$ satisfaisant à $b_i = 0$ (resp. $b_i = 1$). L'expression précédente peut se simplifier au moyen de l'approximation dite *max-log sum* (dite aussi *max-log*), selon laquelle on approche les sommes par les termes de probabilité prépondérants :

$$LLR(b_i) \simeq \max_{\mathbf{s}_1 \in C_1^i} \log\left(p(\mathbf{r}|\mathbf{s}_1)\right) - \max_{\mathbf{s}_0 \in C_0^i} \log\left(p(\mathbf{r}|\mathbf{s}_0)\right) \qquad (9)$$

soit encore :

$$LLR(b_i) \simeq \min_{\mathbf{s}_0 \in C_0^i} \left(d_\gamma^2(\mathbf{r},\mathbf{s}_0)\right) - \min_{\mathbf{s}_1 \in C_1^i} \left(d_\gamma^2(\mathbf{r},\mathbf{s}_1)\right) \qquad (10)$$

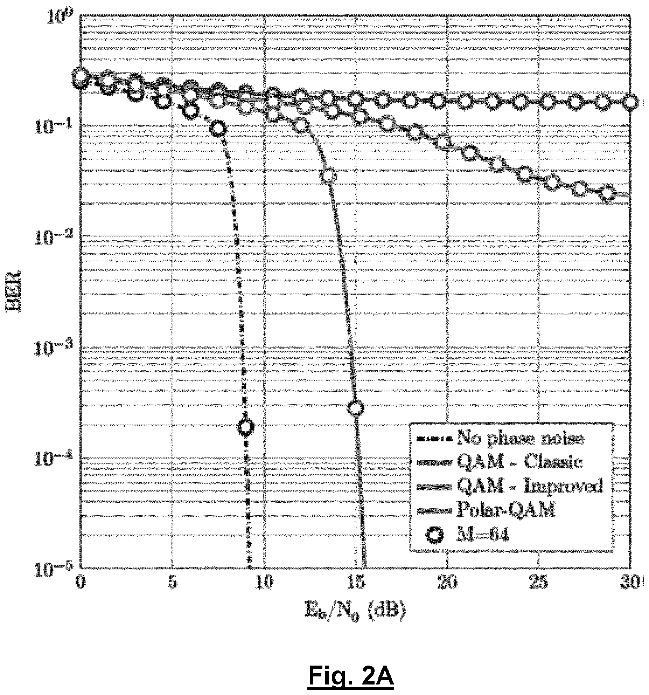

Les Figs. 2A-2B représentent des courbes de taux d'erreur binaire en fonction du rapport $E_b / N_0$ pour une modulation PQAM et une méthode QAM classique.

Le rapport signal sur bruit est égal à $E_s/(N_0 / 2)$ où $E_s = mE_b$ est l'énergie par symbole, $E_b$ est l'énergie par bit et $N_0$ la densité spectrale bilatérale de bruit.

Les courbes sont données pour une puissance de bruit de phase $$\sigma_p^2 = 0.1$$ .

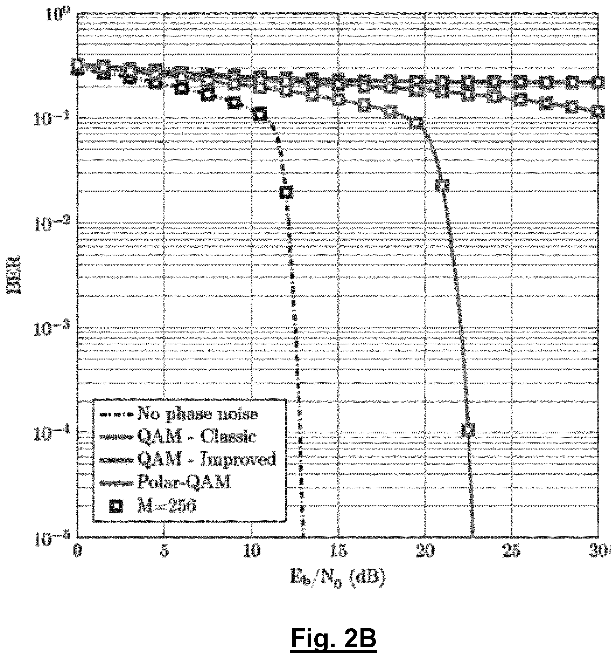

Dans le cas de la Fig. 2A, la modulation utilisée était d'ordre M = 64 (mots sont de taille m = 6 bits) et dans celle de la Fig. 2B elle était d'ordre M =256 (mots sont de taille $m$ = 8 bits), le nombre de cercles concentriques était de $\Gamma$ = 8 dans le cas de la Fig. 2A et de $\Gamma$ = 32 dans celui de la Fig. 2B.

Les mots faisant l'objet de la modulation numérique sont issus d'un codage LDPC de rendement 2/3 avec des longueurs de blocs de 1944 bits et un décodage souple de type *min-sum* et 50 itérations de décodage.

On constate que le niveau de BER obtenu au moyen de la méthode de modulation PQAM (ou Polar-QAM sur les figures) est sensiblement inférieur à celui d'une modulation QAM classique de même ordre, le décrochement intervenant pour un SNR de 13 dB lorsque $M$ = 64 et de 20 dB lorsque $M$ = 256.

La modulation PQAM exposée ci-dessus est utilisée dans un mécanisme d'adaptation de liaison (encore dénommé quelquefois mécanisme d'adaptation de lien) selon un mode de réalisation de l'invention. On rappelle que l'adaptation d'une liaison consiste à modifier de manière adaptative le schéma de modulation et de codage (schéma MCS) des bits d'information en fonction de la qualité du canal (notamment son rapport signal sur bruit), pour obtenir un BER cible pour un débit donné, ou inversement obtenir un débit cible à partir d'un BER donné.

Dans le cas présent, et de manière originale, il sera également tenu compte du bruit de phase dans l'adaptation de la liaison.

Le taux d'erreur binaire, $p_{be} = \dfrac{p_{se}}{m}$ peut être calculé de manière analytique au moyen de :

$$p_{se} = 1 - \Pr\left(\hat{\mathbf{s}} = \mathbf{s}\,|\,\mathbf{s}\right) = 1 - \left[ \Pr\left(-\frac{\delta\rho}{2} < \Delta\rho < \frac{\delta\rho}{2}\right) \Pr\left(-\frac{\delta\theta}{2} < \Delta\theta < \frac{\delta\theta}{2}\right) \right] \quad (12)$$

la région de décision ML $\hat{\mathbf{s}}=\mathbf{s}$ étant définie par les plages $\delta\rho$, $\delta\theta$ autour du symbole s .

$$p_{se} \simeq 2\left[ Q\left(\frac{\delta\rho}{2\sigma_n}\right) + Q\left(\frac{\delta\theta}{2\sqrt{\sigma_p^2 + \sigma_n^2 / E_s}}\right) \right] \quad (13)$$

où $Q(x) = \dfrac{1}{\sqrt{2\pi}} \displaystyle\int_x^\infty \exp\left(-\frac{u^2}{2}\right) du$ est la fonction de répartition complémentaire de la loi normale centrée réduite, N(0,1). En tenant compte des expressions de $\delta\rho$ et $\delta\theta$ en fonction de M et $\Gamma$, et du fait que $E_b = E_s / m$ :

$$p_{be} \simeq \frac{2}{m}\left[ Q\left(\sqrt{\frac{3SNR}{4\Gamma^2 - 1}}\right) + Q\left(\frac{\pi\Gamma}{M\sqrt{\sigma_p^2 + 1/SNR}}\right) \right] \quad (14)$$

où $SNR = \dfrac{2mE_b}{N_0}$ .

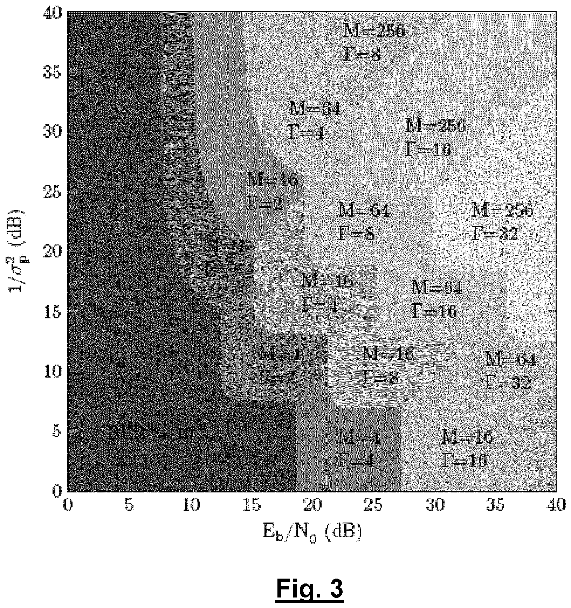

La Fig. 3 représente un diagramme de sélection d'une constellation de modulation PQAM par une méthode d'adaptation de liaison selon un mode de réalisation de l'invention.

Plus précisément ce diagramme donne pour un taux d'erreur binaire cible (ici $BER < 10^{-4}$) les constellations de modulation compatibles avec un niveau de bruit de phase donné et un niveau de bruit thermique donné. On a représenté en abscisses le rapport signal sur bruit, $E_b / N_0$, et en ordonnées l'inverse de la puissance du bruit de phase, $\dfrac{1}{\sigma_p^2}$ .

Ce diagramme est obtenu en calculant le BER à partir de l'expression (14), en fonction du rapport signal sur bruit $E_b / N_0$ et de la puissance de bruit de phase, $\sigma_p^2$ , ce pour différentes valeurs de $M$ et $\Gamma$. Les valeurs de $M$ et $\Gamma$ compatibles avec le BER cible sont indiquées dans le diagramme.

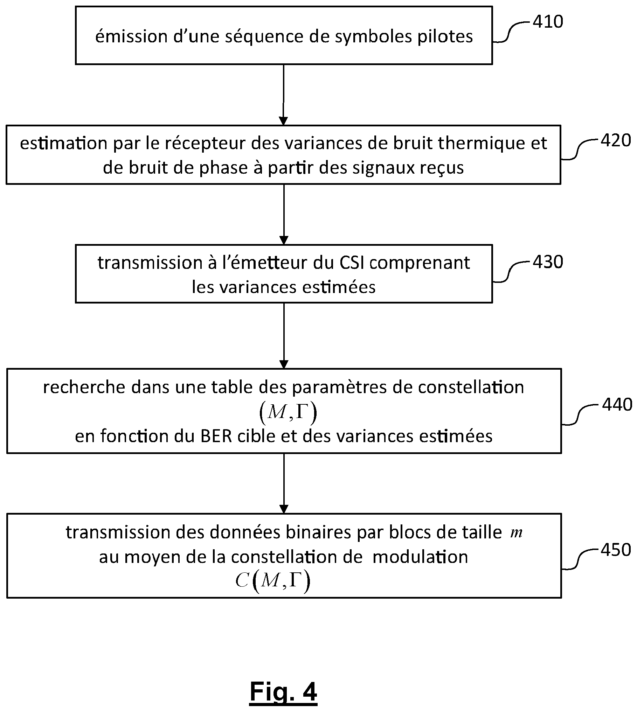

La Fig. 4 représente l'organigramme d'une méthode d'adaptation de liaison selon un mode de réalisation de l'invention.

A l'étape 410, l'émetteur transmet une pluralité N de symboles pilotes, par exemple dans un entête de trame de transmission. Ces symboles pilotes sont par définition connus du récepteur et ne font pas nécessairement partie d'une constellation $C(M,\Gamma)$ au sens défini plus haut. On choisira par exemple des symboles de même amplitude $\sqrt{E_s}$ .

A l'étape 420, le récepteur estime, à partir du signal reçu, les variances de bruit thermique (ou bruit additif) et de bruit de phase affectant le canal de transmission. Plus précisément :

$$\sigma_n^2 = \frac{1}{N}\sum_{k=1}^{N}\left(\rho_k - \sqrt{E_s}\right)^2 \qquad\qquad (15\text{-}1)$$

et

$$\sigma_p^2 = \frac{1}{N}\sum_{k=1}^{N}\left(\theta_k - \arg\left(\mathbf{s}_k\right)\right)^2 - \frac{\sigma_n^2}{E_s} \qquad\qquad (15\text{-}2)$$

où $\mathbf{s}_k$, $k = 1,...,N$ sont les symboles pilotes, et $r(k) = \rho_k e^{j\theta_k}$, $k = N$ , les signaux reçus en bande de base, correspondant à ces symboles pilotes.

A l'étape 430, le récepteur retourne à l'émetteur une information d'état de canal ou CSI (*Channel State Information)* comprenant une estimation de la variance bruit de phase et une estimation de la variance du bruit thermique

$$\frac{E_s}{\sigma_n^2} = \frac{mE_b}{\sigma_n^2} )$$

(ou bien du SNR, .

A l'étape 440, l'émetteur consulte une table dont les entrées (discrétisées) sont le taux d'erreur binaire (BER) cible ainsi que les variances de bruit thermique et de bruit de phase. Cette table donne les valeurs optimales des paramètres $M,\Gamma$ compatibles avec le triplet d'entrées fournies (à savoir la variance de bruit additif, la variance du bruit de phase et le taux d'erreur binaire cible).

Le cas échéant cette table comporte également en entrée les paramètres de différents types de codage canal avec différents rendements. Dans tous les cas, la table en question a été précalculée et stockée dans une mémoire de l'émetteur. Elle contient les valeurs $M,\Gamma$ des constellations $C(M,r)$ compatibles avec le triplet d'entrées fournies. Plus particulièrement, elle contient les valeurs optimales $M,\Gamma$ vérifiant la contrainte :

$$\frac{2}{m}\left[Q\left(\sqrt{\frac{6E_s/\sigma_n^2}{4\Gamma^2-1}}\right) + Q\left(\frac{\pi\Gamma}{M\sqrt{\sigma_p^2 + 1/\left(2E_s/\sigma_n^2\right)}}\right)\right] \le BER \qquad\qquad (16)$$

avec les mêmes conventions de notation que dans l'expression (14).

A l'étape 450, l'émetteur module les données binaires (le cas échéant après les avoir codées au moyen d'un codage canal) en groupant par blocs de $\log_2(M)$ bits pour générer les symboles de modulation correspondant de la constellation $C(M,\Gamma)$. Ces symboles de modulation modulent ensuite une porteuse au moyen d'une modulation en quadrature, de manière connue en soi.

**Revendications**

1. Méthode d'adaptation de liaison entre un émetteur et un récepteur, l'émetteur groupant des données binaires à transmettre sous forme de blocs de longueur $m = \log_2 M$ , et transformant lesdits blocs en des symboles complexes au moyen d'une modulation numérique pour les transmettre sur un canal de transmission, lesdits symboles appartenant à une constellation de modulation polaire $C(M,\Gamma)$, d'ordre M constituée de $\Gamma = 2^n$ cercles concentriques équidistants où $m > n+1$ et $n > 1$, chacun des cercles concentriques portant une même pluralité $M/\Gamma$ de symboles, la distribution angulaire desdits symboles étant uniforme et identique sur chacun des cercles concentriques, deux symboles successifs sur un cercle correspondant à deux mots de $m$ bits présentant une distance de Hamming égale à 1 et deux symboles, dans une même direction angulaire, appartenant à deux cercles concentriques successifs, correspondant à deux mots de $m$ bits présentant une distance de Hamming égale à 1, dans laquelle méthode:

   - l'émetteur transmet (410) une séquence de symboles pilotes au récepteur via le canal de transmission ; ladite méthode d'adaptation de liaison **étant caractérisée en ce que:**
   - le récepteur déduit (420) des symboles pilotes reçus une estimation de la variance du bruit additif ainsi qu'une estimation de la variance du bruit de phase affectant le canal de transmission et renvoie (430) à l'émetteur, au moyen d'un indicateur d'état du canal, les variances estimées ;
- l'émetteur lit (440) dans table stockée dans une mémoire, à partir des valeurs desdites variances et d'un taux d'erreur binaire cible, un ordre M ainsi qu'un nombre $\Gamma$ de cercles concentriques compatibles avec un taux d'erreur binaire cible ;
- l'émetteur transmet (450) sur la liaison lesdites données binaires au moyen de la constellation de modulation polaire $C(M,\Gamma)$d'ordre $M$ et de nombre de cercles concentriques, $\Gamma$ ainsi lus dans la table.

2. Méthode d'adaptation de liaison selon la revendication 1, **caractérisée en ce que** pour un taux d'erreur binaire cible *BER,* un couple de variances de bruit additif $\sigma_n^2$ et un bruit de phase $\sigma_p^2$ , la table contient un couple de

$$\frac{2}{m}\left[Q\left(\sqrt{\frac{6E_s/\sigma_n^2}{4\Gamma^2-1}}\right)+Q\left(\frac{\pi\Gamma}{M\sqrt{\sigma_p^2+1/\left(2E_s/\sigma_n^2\right)}}\right)\right]\leq BER$$

paramètres optimaux $M,\Gamma$, vérifiant                                                                                          où Q(.) est la fonction de répartition complémentaire de loi normale centrée réduite et $E_s$ est l'énergie par symbole.

3. Méthode d'adaptation de liaison selon la revendication 1, **caractérisée en ce que** la table comporte également en entrée des paramètres de différents types de codage canal.


**Patentansprüche**

1. Verfahren zur Anpassung einer Verbindung zwischen einem Sender und einem Empfänger, wobei der Sender zu übertragende Binärdaten in Form von Blöcken der Länge m = $\log_2 M$ gruppiert und die Blöcke mittels digitaler Modulation in komplexe Symbole umwandelt, um sie auf einem Übertragungskanal zu übertragen, wobei die Symbole zu einer polaren Modulationskonstellation $C(M, \Gamma)$ der Ordnung M gehören, die aus $\Gamma=2^n$ äquidistanten konzentrischen Kreisen mit m > *n+1* und *n* > 1 besteht, wobei jeder der konzentrischen Kreise eine gleiche Vielzahl M / $\Gamma$ von Symbolen trägt, wobei die Winkelverteilung der Symbole auf jedem der konzentrischen Kreise gleichmäßig und identisch ist, wobei zwei aufeinanderfolgende Symbole auf einem Kreis zwei m-Bit-Worten entsprechen, die einen Hamming-Abstand gleich 1 aufweisen, und zwei Symbole in derselben Winkelrichtung, die zu zwei aufeinanderfolgenden konzentrischen Kreisen gehören, zwei m-Bit-Worten entsprechen, die einen Hamming-Abstand gleich 1 aufweisen, wobei bei dem Verfahren

- der Sender eine Sequenz von Pilotsymbolen über den Übertragungskanal an den Empfänger sendet (410);

wobei das Verfahren zur Anpassung der Verbindung **dadurch gekennzeichnet ist, dass**

- der Empfänger aus den empfangenen Pilotsymbolen eine Schätzung der Varianz des additiven Rauschens sowie eine Schätzung der Varianz des den Übertragungskanal beeinflussenden Phasenrauschens ableitet (420) und die geschätzten Varianzen mit Hilfe eines Kanalzustandsindikators an den Sender zurücksendet (430);
- der Sender aus einer in einem Speicher gespeicherten Tabelle ausgehend von den Werten der Varianzen und einer Ziel-Bitfehlerrate eine Ordnung M sowie eine Anzahl $\Gamma$ von konzentrischen Kreisen ausliest (440), die mit einer Ziel-Bitfehlerrate kompatibel sind;
- der Sender auf der Verbindung die genannten Binärdaten mittels der polaren Modulationskonstellation $C(M, \Gamma)$ mit der Ordnung M und der Anzahl konzentrischer Kreise $\Gamma$, die so aus der Tabelle ausgelesen wurden, überträgt (450).

2. Verfahren zur Verbindungsanpassung nach Anspruch 1, **dadurch gekennzeichnet, dass** für eine Ziel-Bitfehlerrate *BER,* einem Paar von Varianzen aus additivem Rauschen $\sigma_n^2$ und Phasenrauschen $\sigma_p^2$ die Tabelle ein Paar von

$$\frac{2}{m}\left[Q\left(\sqrt{\frac{6E_s/\sigma_n^2}{4\Gamma^2-1}}\right)+Q\left(\frac{\pi\Gamma}{M\sqrt{\sigma_p^2+1/(2E_s/\sigma_n^2)}}\right)\right]\leq BER$$

optimalen Parametern M, $\Gamma$ enthält, die

erfüllen, worin Q(.) die komplementäre Verteilungsfunktion der reduzierten zentrierten Normalverteilung ist und $E_s$ die Energie pro Symbol ist.

**3.** Verfahren zur Verbindungsanpassung nach Anspruch 1, **dadurch gekennzeichnet, dass** die Tabelle als Eingabe auch Parameter verschiedener Arten von Kanalcodierung enthält.


**Claims**

**1.** Method for adapting a link between an emitter and a receiver, the emitter grouping together binary data to be transmitted in the form of blocks having a length $m = \log_2 M$, and transforming said blocks into complex symbols via digital modulation to transmit them over a transmission channel, said symbols belonging to a polar-modulation constellation $C(M,\Gamma)$ of order $M$ consisting of $\Gamma = 2^n$ equidistant concentric circles where $m>n+1$ and $n>1$, each of the concentric circles carrying the same plurality $M/\Gamma$ of symbols, the angular distribution of said symbols being uniform and identical on each of the concentric circles, two successive symbols on a circle corresponding to two words of m bits having a Hamming distance equal to 1 and two symbols, in the same angular direction, belonging to two successive concentric circles, corresponding to two words of m bits having a Hamming distance equal to 1, said method for adapting a link wherein:

- the emitter transmits (410) a sequence of control symbols to the receiver via the transmission channel;

said method for adapting a link being **characterized in that**:

- the receiver derives (420), from the control symbols received, an estimation of the variance in the additive noise as well as an estimation of the variance in the phase noise affecting the transmission channel and sends back (430) to the emitter, via an indicator of state of the channel, the estimated variances;
- the emitter reads (440) in a table stored in a memory, on the basis of the values of said variances and a target bit error rate, an order M as well as a number $\Gamma$ of concentric circles compatible with a target bit error rate;
- the emitter transmits (450), over the link, said binary data via a modulation constellation of order M and having a number of concentric circles, $\Gamma$, thus read in the table.

**2.** Method for adapting a link according to claim 1, **characterized in that** for a target bit error rate *BER,* a pair of variances in additive noise $\sigma_n^2$ and a phase noise $\sigma_p^2$, the table contains a pair of optimal parameters $M,\Gamma$,

$$\frac{2}{m}\left[Q\left(\sqrt{\frac{6E_s/\sigma_n^2}{4\Gamma^2-1}}\right)+Q\left(\frac{\pi\Gamma}{M\sqrt{\sigma_p^2+1/\left(2E_s/\sigma_n^2\right)}}\right)\right] \leq BER$$

satisfying , where $Q(.)$ is the complementary distribution function of the reduced centered normal distribution and $E_s$ is the energy per symbol.

**3.** Method for adapting a link according to claim 1, **characterized in that** the table also includes as an input parameters of various types of channel coding

**Fig. 1**

**Fig. 2A**

**Fig. 2B**

**Fig. 3**

émission d'une séquence de symboles pilotes ⟍410

estimation par le récepteur des variances de bruit thermique et de bruit de phase à partir des signaux reçus ⟍420

transmission à l'émetteur du CSI comprenant les variances estimées ⟍430

recherche dans une table des paramètres de constellation $(M, \Gamma)$ en fonction du BER cible et des variances estimées ⟍440

transmission des données binaires par blocs de taille $m$ au moyen de la constellation de modulation $C(M, \Gamma)$ ⟍450

## Fig. 4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **C. HÄGER et al.** Design of APSK constellations for coherent optical channels with nonlinear phase noise. *IEEE Transactions on Communications,* Août 2013, vol. 61 (8

- **L. DENG et al.** Performance of circular QAM constellations using partial channel coding with parallel double gray mapping. *Int'l Symposium on Wireless Personal Multimedia Communications (WPMC),* 14 Novembre 2016